# EUROPEAN PATENT SPECIFICATION

(11) **EP 1 381 153 B1**
(45) Date of publication and mention of the grant of the patent: **14.09.2005**
(21) Application number: 02360209.7
(22) Date of filing: 12.07.2002
(51) Int. Cl.: H03D 13/00, H03L 7/085, H04J 3/04, H04J 3/06

(54) **Multiplexer input circuit with DLL phase detector**
Eingangsschaltung für einen Multiplexer mit einem DLL Phasendetector
Circuit d'entrée pour un multiplexeur avec détection de phase utilisé en boucle à retard de phase (DLL)

(43) Date of publication of application: 14.01.2004
(73) Proprietor: ALCATEL, 75008 Paris (FR)
(72) Inventor: Wedding, Berthold, 70825 Korntal-Münchingen (DE)
(74) Representative: Rausch, Gabriele

(56) References cited:
- EP-A- 0 499 479
- WO-A-02/19528
- US-A- 3 805 180
- US-A- 5 432 826
- US-A- 5 659 719
- US-A- 6 114 879

## Description

For exactly controlling the switching of a multiplexer to the inputs of which digital signals to be multiplexed are fed, especially at frequencies of 10 GHz or higher, it is necessary to have a clock for controlling the multiplexer or for controlling another device, for example a device for pulse shaping, which clock is in an exact relationship to the input signals to be multiplexed or pulse shaped.

From US 3 805 180 a time recovery circuit for a binary coded signal is known. The binary coded signal is applied to the clock terminal of a first D type flip flop, while a clock signal derived from a voltage controlled oscillator is applied to a D input of the first flip flop. The output signal of the voltage control oscillator represents the above mentioned clock signal and is additionally applied to a clock terminal of a second flip flop. The second flip flop receives additionally the binary coded signal and its D input. The output of the flip flop provides the recovered signal.

WO 02/19528 describes a data recovery procedure comprising a feed-back of a recorded signal in the recovery process. The described device includes a data sampler, a compare logic, a phase controller and a phase shifter. The data sampler converts an input data stream into three data streams which are again converted by the compare logic into two different signals. The different signals are processed and transferred to a phase shifter. The phase shifter splits and shifts the phase of the input clock to generate three phase clocks. With the help of these three phase clocks the data can be recovered.

It is an object of the invention, to provide an arrangement and method which makes sure that the phase relationship between the input data signal and a clock signal for controlling the multiplexer or other device has the desired value.

This object is achieved in a first aspect of the invention in that an input circuit, for a multiplexer, for phase controlling of a data input signal with a clock signal, comprises a flip-flop, wherein the data signal is fed to a clock input of the flip-flop and the clock signal is fed to the data input of the flip-flop, and wherein the data output of the flip-flop is used as a control signal of a locked loop, wherein the data input signal is provided by a data source, wherein the data source is part of a locked loop and controls the phase of the data input signal in dependence of an adjusting signal which is input to the data source, wherein the locked loop delivers the adjusting signal to the data source.

Though the phase relationship is originally unknown, the invention presumes, that the clock frequency of the input data signals is known. The value of the clock frequency of the input data signal may be clearly defined in the design of the telecommunications system or apparatus (e.g. provided by a master clock source), or said frequency is known exactly from a measurement or a clock recovery device which sets the frequency of the local clock. In the following description, it is further assumed that for the proper function of the described devices and methods, it is necessary, that the clock frequency of the data input signals and of the for example locally produced clock signal is the same; however, dependent on the special constructions of devices used for the data sources, for the multiplexer or pulse shaping, it may be that such devices require a clock frequency higher or lower than the bit frequency of the input data signals.

An advantage of the invention is, that it is of simple design which makes the invention especially useful for high frequencies as mentioned above. The data output of the flip-flop is dependent on the phase relationship of the data input signal with respect to the clock signal.

The locked loop controlled by the output signal of the flip-flop is in the described examples a delay locked loop (DLL). However the invention takes into account, that in some cases instead of a DLL a PLL (phase locked loop) may be used. In embodiments of the invention, the DLL is made by inserting a controllable phase shifter into the path of clock signals of a local clock generator or a local clock signal source, wherein the control signals of the DLL are fed to a control input of the controllable phase shifter.

The flip-flop may be of any usable construction. In embodiments of the invention described, a D-flip-flop is used for the flip-flop. The D-flip-flop at the occurrence of a first edge of the signal provided to a clock input of the D-flip-flop stores the value of a signal at a data input of the D-flip-flop. On the occurrence of the next edge of the signal fed to the clock input, the stored value is delivered to an output terminal of the D-flip-flop. In variants, the arrangement may be such that more than two edges of the signal fed to the clock input are necessary in order to "transport" the signal of the data input of the D-flip-flop or other flip-flop to the output terminal.

The invention is useful, when the data source or data sources from which the data input signal or signals come, is provided with clock signals from a master clock generator which also provides the apparatus of the invention with clock signals. Since normally each data source of digital signals requires a clock signal, the invention can be used in such cases where the data source is located in a distance from the local clock generator which distance allows providing the clock signals of the master clock generator to the data source. The data source in this case is part of the locked loop or feedback control arrangement. The phase position of the data signals provided by the data source is adjusted by the clock signals delivered to the data source.

The invention as defined in claim one and referred to above allows different manners of realisation.

In embodiments of the invention, the input circuit comprises a further flip-flop, wherein the data signal is fed to a data input of the further flip-flop and the clock signal is fed to the clock input of the further flip-flop.

This embodiment is of advantage when a data signal has to be brought into proper phase relationship with a local clock signal, which data signal comes from a data source which is not controlled by a master clock which also controls the multiplexer or pulse shaping device mentioned above. This embodiment is also usable when the further flip-flop is used only for pulse shaping.

In an embodiment of the invention, the locked loop is arranged to adjust the phase of the clock signal which is provided to the clock input of the further flip-flop.

In this case, the flip-flop in the data path is used for adjusting the phase. It is not necessary that the clock signal fed to the data input of that flip-flop which provides the control output signal is also adjusted in phase.

In an embodiment of the invention the locked loop is arranged to adjust the phase of the clock signal which is provided to the data input of the flip-flop.

This embodiment may be used in cases where the data source cannot be controlled in phase with a clock signal derived from a master clock signal of the present inventive device by phase shifting.

In an embodiment of the invention the locked loop comprises a controllable phase shifter (thus being a delay locked loop) and is arranged to adjust the phase of the clock signal which is provided to the data input of the flip-flop.

This is the embodiment discussed immediately before, provided in addition with a phase shifter and provides therefore a DLL.

In an embodiment of the invention, the multiplexer has a plurality of data input terminals to be provided with data signals, a data output and a clock input, wherein a said data signal is fed to a clock input of the flip-flop and the clock signal is fed to the clock input of the multiplexer.

In this embodiment, the further flip-flop mentioned further above is not provided. The multiplexer may work in addition to its multiplexing function as a pulse shaping device. Such pulse shaping is often a normal function of multiplexers. Nevertheless, especially in the field of bit frequencies mentioned above (10 Gbit/s or higher) the special pulse forming devices (for example flip-flops) are often preferred.

In such case, such a pulse forming device may be followed by a multiplexer, as is the case in an embodiment of the invention, in which the multiplexer has a plurality of data inputs to be provided with data signals, a data output and a clock input, wherein a number of further flip-flops for a plurality of data signals is provided, which number corresponds to the number of data inputs of the multiplexer, and the clock input of the multiplexer is provided with a clock signal. The invention also concerns a method which performs the steps discussed above, such method for phase controlling of the data signal with a clock signal comprises: scanning the clock signal with an edge of the data signal, deriving from the scanning result a control signal, using the control signal for adjusting the phase relationship between the data signal and the clock signal, and inputting the adjusting signal into the data source and controlling the phase of the data input signal in dependence of the adjusting signal by the data source.

Advantages of the method correspond to advantages mentioned above.

Further features and advantages of the invention will be apparent from the following description of preferred variants and embodiments of the invention in connection with the drawings, which show features essential for the invention, and in connection with the claims. The individual features may be realised individually or in any combination in an embodiment of the invention.
Figure 1 is a block diagram of a basic circuit of the invention.
Figure 2 is a block diagram of an embodiment for adjusting the phase for a digital signal sent by a data source which is not contolled by the clock signal of figure 2.
Figure 3 is a block diagram of an embodiment for adjusting the phase of digital signals of two data sources.
Figure 4 is the principle of a multiplexer 4:1.
Figure 5 is a time diagram of a clock signal and a data signal.

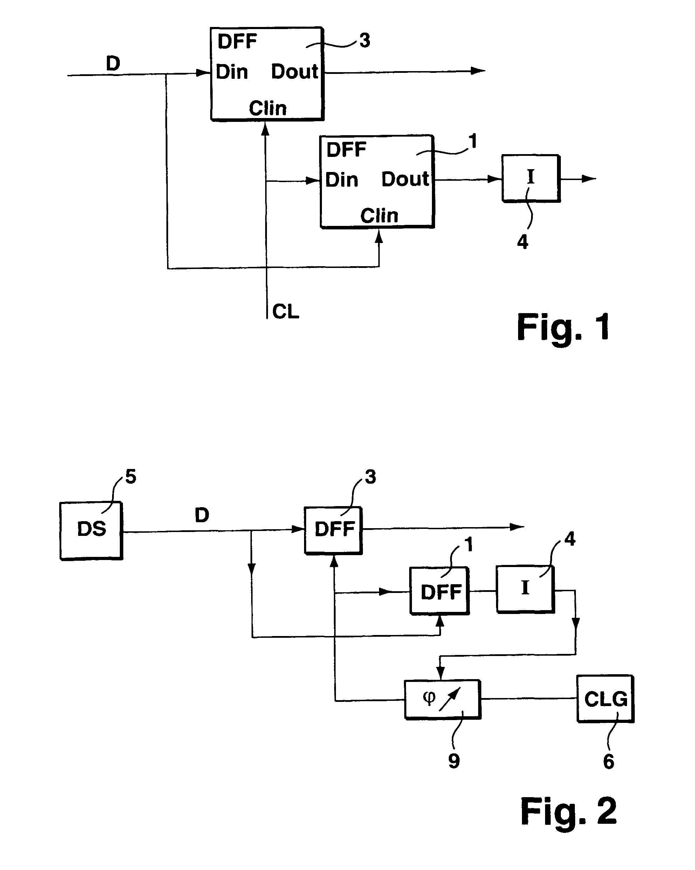

In figure 1 a flip-flop 1 and a further flip-flop 3 are provided. The flip-flops are D-flip-flops in the example and, therefore, designated with the letters DFF. Each of the flip-flops has a data input terminal Din and a data output terminal Dout, and further a clock input terminal Clin. A data input signal D is fed to the data input of the further flip-flop 3 and to the clock input of the flip-flop 1. A clock signal CL is fed to the clock input of the further flip-flop 3 and to the data input of the flip-flop 1.

The output terminal of the flip-flop 1 is connected to an integrator (I) 4. In the circuitry of figure 1 the flip-flop 1 performs scanning of the clock signal CL by the data signal. The result (the data output) is a wave form having a D.C. voltage content or component. The value of the D. C. voltage content is dependent on the phase relationship between the clock signal and the data signal. The integrator 4 delivers at its output this D. C. voltage or component of the data output, which D.C. voltage in the embodiments of the invention is used as control signal.

In figure 1, the phase relationship between the data signal and the clock signal is determined only by the flip-flop 1. Therefore, for this function, the flip-flop 3 is not necessary. In figure 1, the flip-flop 3 may serve for pulse shaping of the data signal.

Figure 2 comprises the elements shown in figure 1 and further elements. A data source 5 delivers the digital data D. A clock generator 6 delivers a clock signal to the input of an adjustable phase shifter 9. The output signal of the integrator 4 is connected to a control input of the phase shifter 9. The output of the phase shifter 9 delivers the clock signal CL to the flip-flops 1 and 3. Though the data source 5 for its correct function will be provided with a clock signal, it is not controlled by the clock generator 6 of figure 2. The bit frequency of the data source 5 is measured exactly and the clock frequency of the clock generator 6 is adjusted accordingly in a manner not shown. The circuitry of figure 2 is arranged such that the clock signal delivered to the clock input of the flip-flop 3 is in such phase relationship with respect to the digital data that for pulse shaping the digital signal is switched through by the flip-flop 3 in such a way that the pulse form is not deteriorated.

The circuitry of figure 2 performs a closed loop control. In this embodiment, it is a locked loop. Because of the presence of the phase shifter 9, it is a delay locked loop (DLL). The data source 5 is not part of the control loop.

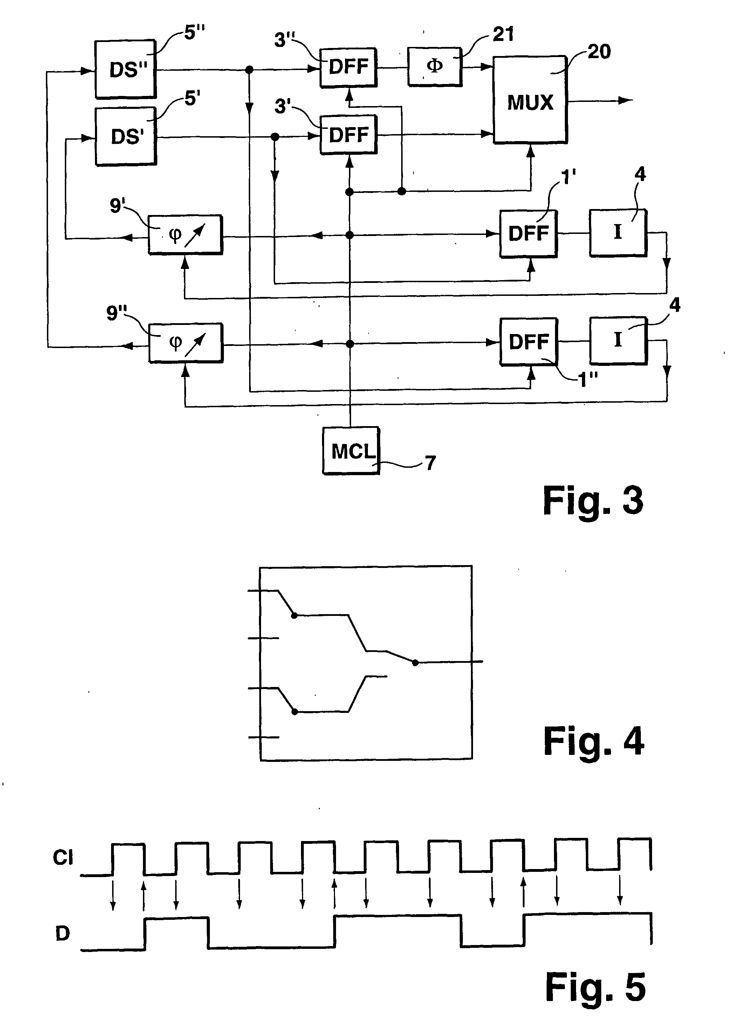

In the embodiment of figure 3, in comparison with figure 2 certain elements are provided in duplicate. Further, additional elements are provided. There are provided two data sources 5' and 5", to flip-flops 1' and 1", and two further flip-flops 3' and 3". The flip-flops 1', 1" and the further flip-flops 3' and 3" are provided with a clock signal from a master clock generator 7 directly. The data sources 5' and 5" are provided with clock signals which stem from the master clock generator 7. The master clock generator 7 is connected to clock inputs of the data sources via adjustable phase shifters 9' and 9". The control inputs of those phase shifters are, similar to figure 2, connected with outputs of integrators 4, which are connected to the outputs of the flip-flops 1' and 1". In this embodiment, the data sources 5' and 5" are part of the closed loop control. The arrangement is such that the data from the data sources 5' and 5" arrive in synchronism at the flipflops 3' and 3". The further flip-flops 3' and 3" serve for pulse shaping only. Their output signals are connected to input terminals of a multiplexer 20. In order to make sure, that the output signals of the further flip-flops 3' and 3" arrive at the multiplexer 20 at different times (as is normally required or preferred for the input signals of a multiplexer), a fixed phase shifter 21 is connected after the flip-flop 3". The phase shifter 21 is advantageously provided by a latch which is coupled to the flip-flop 3".

In the example of figure 3, the data sources deliver the data signals at the speed of about 10 Gbps. The multiplexer 20 combines the two signals to a combined signal having a frequency of about 20 Gbps.

Figure 4 shows the known principle of a 4:1 multiplexer. It comprises three switching elements each connecting two input signals to one output. The rightmost switching element in figure 1 normally is that which has the highest switching speed.

Figure 5 shows a timing diagram of the clock signal CL and of the data signal D in figure 1. In this timing diagram of figure 5, the relative phases of the clock signal and data signal are shown. The arrows indicate the instants of sampling operations in the data flip-flop 3 (arrow downwards) and in the phase detector flip-flop 1 (arrow upwards).

The flip-flops sample the input signals at the data input at a positive transition of the signal at the clock input. Thus the data flip flop (3 in Fig. 1) samples the incoming data signal in the middle of the symbol pulses (see downward arrows in Fig.5). The phase detector flip flop (1 in Fig.1) samples the incoming clock signal at the negative clock transitions (see upward arrows in Fig.5). If the clock signal arrives early, the data flip-flop (3) generates a "low" output signal. If the clock signal arrives late, the data flip-flop (3) generates a "high" output signal.

In order to simplify the description, in the description of figure 3 only a multiplexer 2:1 is mentioned. However, the invention also aims to create a circuitry adapted for a multiplexer 4:1, which combines four signals each having a frequency of about 10 Gbps to a combined data signal having about 40 Gbps. For this purpose, the circuitry shown in figure 3 has to be amended in order to provide a multiplexer 4:1 with input signals which have the correct time sequence with respect to one another. Instead of multiplexers 2:1 or 4:1, as described, other multiplexers may be provided, e.g. 8:1, 16:1, or others.

The circuitry of figure 3 may be varied, if data signals of only one data source or data signals of more than two data sources are to be handled. In the case of one data signal, a function similar to that of figure 2 may be performed; however, the data source would be part of a locked loop.

Instead of D-flip-flops, other suitable flip-flops may be used in other embodiments of the invention.

## Claims

1. Input circuit for a multiplexer, for phase controlling of a data input signal (D) with a clock signal (CL), comprising a flip-flop (1; 1', 1"), wherein the data signal (D) is fed to a clock input (Clin) of the flip-flop (1; 1'; 1") and the clock signal (CL) is fed to the data input (Din) of the flip-flop (1; 1'; 1") and wherein the data output (Dout) of the flip-flop (1; 1'; 1") is used as a control signal of a locked loop, **characterized in that** the data input signal (D) is provided by a data source (5; 5'; 5"), wherein the data source (5; 5'; 5") is part of the locked loop and controls the phase of the data input signal (D) in dependence of an adjusting signal which is input to the data source (5; 5'; 5"), wherein the locked loop delivers the adjusting signal to the data source (5; 5'; 5").

2. Input circuit according to claim 1, **characterized in that** a further flip-flop (3; 3'; 3") is provided, wherein the data signal (D) is fed to a data input (Din) of the further flip-flop (3; 3'; 3") and the clock signal (CL) is fed to the clock input (Clin) of the further flip-flop (3; 3'; 3").

3. Input circuit according to claim 2, **characterized in that** the locked loop is arranged to adjust the phase of the clock signal (CL) which is provided to the clock input (Clin) of the further flip-flop (3; 3'; 3").

4. Input circuit according to claim 3, **characterized in that** the locked loop is arranged to adjust the phase of the clock signal (CL) which is provided to the data input (D) of the flip-flop (1; 1'; 1 ").

5. Input circuit according to claim 3, **characterized in that** the locked loop comprises a controllable phase shifter (9) thus being a delay locked loop, and is arranged to adjust the phase of the clock signal (CL) which is provided to the data input (Din) of the flip-flop (1; 1'; 1").

6. Multiplexer, having a plurality of data inputs (Din) to be provided with data signals (D), a data output (Dout) and a clock input (Clin), wherein a said data signal (D) is fed to a clock input (Clin) of the flip-flop (1; 1',1") and the clock signal (CL) is fed to the clock input (Clin) of the multiplexer, **characterized in that** the multiplexer comprises an input circuit according to claim 1.

7. Multiplexer having a plurality of data inputs (Din) to be provided with data signals (D), a data output (Dout) and a clock input (Dlin), wherein a number of further flip-flops (3; 3'; 3") for a plurality of data signals (D) is provided, which number corresponds to the number of data inputs (Din) of the multiplexer, and the clock input (Dlin) of the multiplexer is provided with a clock signal (CL), **characterized in that** the multiplexer comprises an input circuit according to claim 2.

8. Method for phase controlling of a data signal (D) with a clock signal (CL) comprising: scanning the clock signal (CL) with an edge of the data signal (D), deriving from the scanning result a control signal, using the control signal for adjusting the phase relationship between the data signal (D) and the clock signal (CL), **characterized in that** the method further comprises inputting the adjusting signal into the data source (5; 5'; 5") and controlling the phase of the data input signal (D) in dependence of the adjusting signal by the data source (5; 5'; 5").

## Patentansprüche

1. Eingangsschaltung für einen Multiplexer zur Phasenregelung eines Dateneingangssignals (D) mit einem Taktsignal (CL), umfassend: ein Flipflop (1; 1'; 1"), in welchem das Datensignal (D) auf einen Takteingang (Clin) des Flipflops (1; 1'; 1") geführt wird und das Taktsignal (CL) auf den Dateneingang (Din) des Flipflops (1; 1'; 1") geführt wird und in welchem der Datenausgang (Dout) des Flipflops (1; 1'; 1") als ein Steuersignal eines Regelkreises verwendet wird, **dadurch gekennzeichnet, daß** das Dateneingangssignal (D) durch eine Datenquelle (5; 5'; 5") bereitgestellt wird, wobei die Datenquelle (5; 5'; 5") Teil des Regelkreises ist und die Phase des Dateneingangssignals (D) in Abhängigkeit von einem Einstellsignal regelt, welches an die Datenquelle (5; 5'; 5") eingegeben wird, wobei der Regelkreis das Einstellsignal an die Datenquelle (5; 5'; 5") liefert.

2. Eingangsschaltung nach Anspruch 1, **dadurch gekennzeichnet, daß** ein weiteres Flipflop (3; 3'; 3") bereitgestellt wird, in welchem das Datensignal (D) auf einen Dateneingang (Din) des weiteren Flipflops (3; 3'; 3") geführt wird und das Taktsignal (CL) auf den Takteingang (Clin) des weiteren Flipflops (3; 3'; 3") geführt wird.

3. Eingangsschaltung nach Anspruch 2, **dadurch gekennzeichnet, daß** der Regelkreis angeordnet wird, um die Phase des Taktsignals (CL) einzustellen, welches an den Takteingang (Clin) des weiteren Flipflops (3; 3'; 3") bereitgestellt wird.

4. Eingangsschaltung nach Anspruch 3, **dadurch gekennzeichnet, daß** der Regelkreis angeordnet wird, um die Phase des Taktsignals (CL) einzustellen, welches an den Dateneingang (D) des Flipflops (1; 1'; 1") bereitgestellt wird.

5. Eingangsschaltung nach Anspruch 3, **dadurch gekennzeichnet, daß** der Regelkreis einen regelbaren Phasenschieber (9) umfaßt, folglich ein Verzögerungsregelkreis ist, und angeordnet wird, um die Phase des Taktsignals (CL) einzustellen, welches an den Dateneingang (Din) des Flipflops (1; 1'; 1") bereitgestellt wird.

6. Multiplexer, der aufweist: mehrere Dateneingänge (Din), die mit Datensignalen (D) zu versorgen sind, einen Datenausgang (Dout) und einen Takteingang (Clin), in welchem ein Datensignal' (D) auf einen Takteingang (Clin) des Flipflops (1; 1'; 1") geführt wird und das Taktsignal (CL) auf den Takteingang (Clin) des Multiplexers geführt wird, **dadurch gekennzeichnet, daß** der Multiplexer eine Eingangsschaltung nach Anspruch 1 umfaßt.

7. Multiplexer, der aufweist: mehrere Dateneingänge (Din), die mit Datensignalen (D) zu versorgen sind, einen Datenausgang (Dout) und einen Takteingang (Dlin), in welchem mehrere weitere Flipflops (3; 3'; 3") für mehrere Datensignale (D) bereitgestellt werden, deren Anzahl der Anzahl der Dateneingänge (Din) des Multiplexers entspricht, und der Takteingang (Dlin) des Multiplexers mit einem Taktsignal (CL) versorgt wird, **dadurch gekennzeichnet, daß** der Multiplexer eine Eingangsschaltung nach Anspruch 2 umfaßt.

8. Verfahren zur Phasenregelung eines Datensignals (D) mit einem Taktsignal (CL), umfassend: das Abtasten des Taktsignals (CL) mit einer Flanke des Datensignals (D), das Ableiten eines Steuersignals aus dem Abtastergebnis, das Verwenden des Steuersignals zum Einstellen der Phasenbeziehung zwischen dem Datensignal (D) und dem Taktsignal (CL), **dadurch gekennzeichnet, daß** das Verfahren außerdem das Eingeben des Einstellsignals in die Datenquelle (5; 5'; 5") und das Regeln der Phase des Dateneingangssignals (D) in Abhängigkeit von dem Einstellsignal durch die Datenquelle (5; 5'; 5") umfaßt.

## Revendications

1. Circuit d'entrée pour un multiplexeur, afin de contrôler la phase d'un signal d'entrée de données (D) avec un signal d'horloge (Cl), comprenant une bascule (1 ; 1' ; 1"), dans lequel le signal de données (D) est fourni à une entrée d'horloge (Clin) de la bascule (1 ; 1' ; 1") et le signal d'horloge (CL) est fourni à l'entrée de données (Din) de la bascule (1 ; 1' ; 1") et dans lequel la sortie de données (Dout) de la bascule (1 ; 1' ; 1") est utilisée comme un signal de commande d'une boucle de verrouillage, **caractérisé en ce que** le signal d'entrée de données (D) est fourni par une source de données (5 ; 5' ; 5"), dans lequel la source de données (5 ; 5' ; 5") fait partie de la boucle de verrouillage et contrôle la phase du signal d'entrée de données (D) en fonction d'un signal d'ajustement qui est transmis à la source de données (5 ; 5' ; 5"), dans lequel la boucle de verrouillage délivre le signal d'ajustement à la source de données (5 ; 5' ; 5").

2. Circuit d'entrée selon la revendication 1, **caractérisé en ce qu'**une autre bascule (3 ; 3' ; 3") est prévue, dans lequel le signal de données (D) est fourni à une entrée de données (Din) de l'autre bascule (3 ; 3' ; 3") et le signal d'horloge (CL) est fourni à l'entrée d'horloge (Clin) de l'autre bascule (3 ; 3' ; 3").

3. Circuit d'entrée selon la revendication 2, **caractérisé en ce que** la boucle de verrouillage est agencée pour ajuster la phase du signal d'horloge (CL) qui est fourni à l'entrée d'horloge (Clin) de l'autre bascule (3 ; 3' ; 3").

4. Circuit d'entrée selon la revendication 3, **caractérisé en ce que** la boucle de verrouillage est agencée pour ajuster la phase du signal d'horloge (CL) qui est fourni à l'entrée de données (D) de la bascule (1 ; 1' ; 1").

5. Circuit d'entrée selon la revendication 3, **caractérisé en ce que** la boucle de verrouillage comprend un déphaseur contrôlable (9), étant ainsi une boucle à retard de phase, et est agencée pour ajuster la phase du signal d'horloge (CL) qui est fourni à l'entrée de données (Din) de la bascule (1 ; 1' ; 1").

6. Multiplexeur, possédant une pluralité d'entrées de données (Din) devant être alimentées avec des signaux de données (D), une sortie de données (Dout) et une entrée d'horloge (Clin), dans lequel ledit signal de données (D) est fourni à une entrée d'horloge (Clin) de la bascule (1 ; 1' ; 1") et le signal d'horloge (CL) est fourni à l'entrée d'horloge (Clin) du multiplexeur, **caractérisé en ce que** le multiplexeur comprend un circuit d'entrée selon la revendication 1.

7. Multiplexeur possédant une pluralité d'entrées de données (Din) devant être alimentées avec des signaux de données (D), une sortie de données (Dout) et une entrée d'horloge (Dlin), dans lequel un certain nombre d'autres bascules (3 ; 3' ; 3") destinées à une pluralité de signaux de données (D) est prévu, ledit nombre correspondant au nombre d'entrées de données (Din) du multiplexeur, et l'entrée d'horloge (Dlin) du multiplexeur est alimentée avec un signal d'horloge (Cl), **caractérisé en ce que** le multiplexeur comprend un circuit d'entrée selon la revendication 2.

8. Procédé de contrôle de phase d'un signal de données (D) avec un signal d'horloge (CL) comprenant : le scannage du signal d'horloge (CL) avec un flanc du signal de données (D), la dérivation, à partir du résultat du scannage, d'un signal de commande, l'utilisation du signal de commande pour ajuster la relation de phase entre le signal de données (D) et le signal d'horloge (CL), **caractérisé en ce que** le procédé comprend en outre la transmission du signal d'ajustement à la source de données (5 ; 5' ; 5") et le contrôle de la phase du signal d'entrée de données (D) en fonction du signal d'ajustement par la source de données (5 ; 5' ; 5")
